# DEMANDE DE BREVET EUROPEEN

(11) **EP 2 019 567 A1**
(43) Date de publication de la demande: **28.01.2009**
(21) Numéro de dépôt: 08160643.6
(22) Date de dépôt: 17.07.2008
(51) Int. Cl.: H05B 3/00, B29B 13/02, B29C 49/64

(54) **Procédé de détection de l'état d'une lampe de chauffage de corps d'ébauches en matière thermoplastiques et installation de chauffage agencée pour sa mise en oeuvre**

(30) Priorité: 25.07.2007 FR 0705422
(71) Demandeur: Sidel Participations, 76930 Octeville Sur Mer (FR)
(72) Inventeur: Feuilloley, Guy, 76930, OCTEVILLE-SUR-MER (FR)
(74) Mandataire: Cabinet Plasseraud

(57) **Abrégé**

L'invention concerne la détection de l'état d'une lampe (1) de chauffage de corps d'ébauches en matière thermoplastique, en vue de la fabrication de récipients par soufflage ou étirage-soufflage, cette lampe de rayonnement électromagnétique infrarouge possédant une enveloppe (2) notamment en verre ou en quartz entourant un filament (3) ; on équipe la lampe d'un organe (6) électriquement conducteur mécaniquement solidaire de l'enveloppe ; on place l'organe conducteur sous tension électrique et on détecte (en 8) en permanence une grandeur électrique (par exemple sa résistance) aux bornes dudit organe conducteur lorsque la lampe est en fonctionnement ; et on délivre une information représentative de l'état de l'organe conducteur, et donc de l'enveloppe.

## Description

La présente invention concerne d'une façon générale le domaine de la fabrication de récipients en matière thermoplastique par soufflage ou étirage-soufflage d'ébauches (préformes ou récipients intermédiaires) chaudes, et elle concerne plus spécifiquement des perfectionnements apportés aux installations de chauffage des ébauches en préalable à l'étape de soufflage ou d'étirage-soufflage.

Le chauffage des ébauches est effectué en exposant leurs corps à un rayonnement électromagnétique infrarouge de longueur d'onde approprié émis par des lampes à incandescence infrarouges, typiquement en forme générale de tube. Dans la pratique, les ébauches sont déplacées par un transporteur de façon que leurs corps suivent une trajectoire déterminée le long de laquelle sont disposées des lampes de chauffage en nombres et en positions appropriés à l'effet thermique à engendrer au sein de la matière thermoplastique.

Il est connu de surveiller l'état, fonctionnel ou non fonctionnel, des lampes en mettant en oeuvre diverses solutions électriques, dont la plus courante consiste à surveiller l'intensité du courant qui les alimente, soit individuellement, soit par groupe. Ces solutions permettent de détecter la rupture d'un filament.

Toutefois, les lampes utilisées dans les installations précitées sont des lampes à atmosphère d'halogène, qui doivent être maintenues, en fonctionnement, à une température bien définie pour que l'élimination, par l'halogène, des particules de tungstène provenant du filament puisse se réaliser de façon efficace. Si la température de fonctionnement est trop élevée (cas d'une ventilation insuffisante) ou trop basse (cas d'une ventilation excessive), l'élimination des particules de tungstène par l'halogène ne se produit pas, ou se produit de façon insuffisante, et du tungstène se dépose sur l'enveloppe notamment en verre ou en quartz : l'enveloppe finit alors par se désagréger et par casser.

Il a cependant été constaté que la rupture de l'enveloppe ne s'accompagnait pas nécessairement d'une rupture concomitante du filament de la lampe, et il peut s'écouler un laps de temps conséquent (par exemple de plusieurs secondes, voire plusieurs dizaines de secondes) avant qu'intervienne la rupture du filament (rupture provoquée par la mise en contact du filament avec l'oxygène de l'atmosphère ambiante et son oxydation rapide).

De ce fait, les moyens habituellement mis en oeuvre permettant de détecter la rupture du filament ne sont pas efficaces pour déceler la rupture de l'enveloppe qui peut précéder la rupture du filament.

Or, le bris de l'enveloppe d'une lampe est loin d'être un évènement anodin et il peut entraîner des dommages considérables : les morceaux notamment de verre ou de quartz de l'enveloppe peuvent détruire des lampes adjacentes ; ils peuvent endommager les ébauches en cours de défilement et les rendre impropres à un emploi commercial ; voire ils peuvent se loger dans l'une d'elles et demeurer ultérieurement jusque dans le récipient final ; ils peuvent endommager des parties mécaniques de l'installation et causer des grippages dans l'installation fonctionnant à des vitesses considérables. Dans tous les cas, il y a nécessité d'un arrêt d'urgence de l'installation entraînant une perte de production. Enfin, les débris d'enveloppe peuvent causer des blessures au personnel chargé de la remise en état de l'installation.

Les moyens actuels, dont la mise en oeuvre est fondée essentiellement sur l'état physique du filament de la lampe, ne permettent pas de détecter le seul bris de l'enveloppe alors que le filament est encore intact.

L'invention a essentiellement pour but de proposer des moyens (procédé et installation) qui soient propres à déceler le bris de l'enveloppe dès que celui-ci survient et alors que le filament peut, quant à lui, être toujours intact, de manière que des mesures puissent être aussitôt prises pour éviter des conséquences graves dans le fonctionnement de l'installation de chauffage et/ou des blessures au personnel d'accompagnement et de maintenance.

A ces fins, selon un premier de ses aspects, l'invention propose un procédé de détection de l'état d'au moins une lampe de chauffage de corps d'ébauches en matière thermoplastique, en vue de la fabrication de récipients par soufflage ou étirage-soufflage, cette lampe étant une lampe à incandescence de rayonnement électromagnétique infrarouge qui possède une enveloppe entourant un filament, lequel procédé se caractérise, conformément à l'invention,
en ce qu'on équipe ladite lampe d'un organe électriquement conducteur qui est mécaniquement solidaire de ladite enveloppe,
en ce qu'on place ledit organe conducteur sous tension électrique et on détecte en permanence une grandeur électrique aux bornes dudit organe conducteur lorsque la lampe est en fonctionnement, et
en ce qu'on délivre une information représentative de l'état de l'organe conducteur, et donc de l'enveloppe.

En théorie, toute grandeur électrique (tension aux bornes, intensité du courant le traversant, résistance électrique) peut être exploitée pour procurer l'information instantanée souhaitée. Cependant, de façon pratique la détection d'un seuil de tension ou d'un seuil d'intensité n'est pas simple à réaliser dans des conditions d'exploitation courante d'une installation en raison des variations de tension et/ou d'intensité susceptibles de se produire selon le mode de fonctionnement (à pleine puissance ou à puissance réduite), selon le nombre de lampes en fonctionnement, selon la température au sein de l'installation, etc. En outre il serait nécessaire d'avoir recours à un matériel onéreux.

Par conséquent, la solution qui paraît la plus avantageuse et la moins contraignante structurellement et économiquement consiste en ce qu'on détecte en permanence la résistance électrique aux bornes dudit organe conducteur lorsque la lampe est en fonctionnement et en ce qu'on délivre un signal si la résistance mesurée dudit organe conducteur devient supérieure à un seuil prédéterminé, notamment devient sensiblement infinie. Le signal ainsi généré peut ensuite être exploité de toute façon appropriée, par exemple pour déclencher une coupure de l'alimentation électrique de la lampe et/ou une alerte et/ou pour commander l'arrêt du chauffage, voire même l'arrêt de l'installation si cela est envisageable.

Un mode de mise en oeuvre simple des dispositions de l'invention peut consister en ce qu'il soit prévu plusieurs lampes de chauffage chacune équipée d'un organe conducteur qui est mécaniquement solidaire de sa propre enveloppe, en ce que tous les organes soient électriquement indépendants les uns des autres et en ce que la détection de la susdite grandeur électrique soit menée sur chaque organe conducteur de chaque lampe. Autrement dit, dans ce cas chaque lampe est surveillée individuellement et une alarme peut signaler exactement la lampe qui est concernée en cas d'incident. Un tel mode de mise en oeuvre offre l'avantage de la précision et donc de la rapidité d'intervention pour le remplacement de la lampe défectueuse et la remise en fonctionnement de l'installation ; par contre, il nécessite un matériel relativement conséquent qui, globalement, est onéreux à l'achat, au montage et à l'entretien.

De ce fait, on peut aussi envisager un autre mode de mise en oeuvre, plus simple et moins coûteux, qui consiste en ce qu'il soit prévu plusieurs lampes de chauffage chacune équipée d'un organe conducteur qui est mécaniquement solidaire de sa propre enveloppe, en ce que plusieurs organes conducteurs appartenant aux lampes respectives d'un groupe de lampes sont connectés électriquement en série les uns avec les autres et en ce que la détection de la susdite grandeur électrique est menée aux bornes de l'ensemble des organes conducteurs en série dudit groupe de lampes. En cas de bris de l'enveloppe d'une lampe, l'alarme est alors donnée pour un groupe de lampes dans lequel est incorporée la lampe concernée, et c'est ensuite au personnel d'entretien de déterminer quelle lampe dudit groupe doit effectivement être traitée.

Selon un second de ses aspects, l'invention propose, pour la mise en oeuvre du procédé précédent, une installation de chauffage des corps d'ébauches en matière thermoplastique, en vue de la fabrication de récipients par soufflage ou étirage-soufflage, cette installation de chauffage comportant au moins une lampe à incandescence de rayonnement électromagnétique infrarouge qui possède une enveloppe entourant un filament, laquelle installation se caractérise, étant agencée conformément à l'invention,
en ce que ladite lampe comporte un organe électriquement conducteur qui est mécaniquement solidaire de ladite enveloppe, et
en ce que l'installation comprend
- des moyens de détection propres à détecter en permanence, lors du fonctionnement de l'installation, une grandeur électrique instantanée dudit organe conducteur placé sous tension électrique et
- des moyens indicateurs propres à donner une information représentative de l'état de l'organe conducteur, et donc de l'enveloppe de la lampe.

En particulier, on peut envisager que les moyens indicateurs comprennent des moyens comparateurs propres à comparer la valeur détectée de la grandeur électrique à un seuil prédéterminé et à émettre un signal lorsque ladite grandeur électrique mesurée se situe de façon prédéfinie par rapport audit seuil prédéterminé.

De préférence alors, les moyens de détection sont propres à détecter en permanence, lors du fonctionnement de l'installation, la résistance électrique dudit organe conducteur et les moyens comparateurs sont propres à délivrer un signal lorsque ladite résistance électrique détectée devient supérieure à un seuil prédéterminé, notamment devient sensiblement infinie, caractérisant la rupture de l'organe conducteur et donc de l'enveloppe.

Dans la pratique, la lampe utilisée pour le type de chauffage envisagé est en forme générale de tube ; dans ce cas, on prévoit que l'organe conducteur s'étend sur toute la longueur de l'enveloppe.

L'agencement conforme à l'invention peut donner lieu à diverses réalisations pratiques : il est possible de prévoir que l'organe conducteur soit noyé dans la paroi de l'enveloppe, l'organe conducteur pouvant alors être un fil ou un ruban métallique ; cependant, de façon simple, on peut prévoir que l'organe conducteur adhère à une face de l'enveloppe, et plus particulièrement à la face externe de l'enveloppe, en étant constituée par exemple sous forme d'un revêtement d'un film conducteur de type métallique.

Pour ce qui est de l'agencement de l'installation en vue de l'exploitation pratique de lampes constituées conformément à l'invention, diverses solutions, là aussi, sont envisageables.

Une première solution peut consister en ce que l'installation comporte plusieurs lampes équipées d'organes conducteurs respectifs et en ce que des moyens de détection soient fonctionnellement associés de façon individuelle auxdits organes conducteurs respectifs des lampes. Autrement dit, l'installation est agencée de manière telle que chaque lampe est surveillée individuellement et signalée de façon précise en cas d'avarie.

Cependant, une solution plus économique peut consister en ce que l'installation comporte plusieurs lampes équipées d'organes conducteurs respectifs, en ce que plusieurs organes conducteurs appartenant aux lampes respectives d'un groupe de lampes sont connectés électriquement en série les uns avec les autres et en ce que lesdits moyens de détection sont connectés aux bornes de l'ensemble des organes conducteurs en série dudit groupe de lampes. La signalisation d'un défaut détecté se fait alors par groupe de lampes, et non plus individuellement par lampe, mais le matériel mis en oeuvre à cet effet est plus simple, et donc le coût est moindre.

L'invention sera mieux comprise à la lecture de la description détaillée qui suit de certains modes de réalisation donnés uniquement à titre d'exemples nullement limitatifs. Dans cette description, on se réfère au dessin annexé sur lequel :

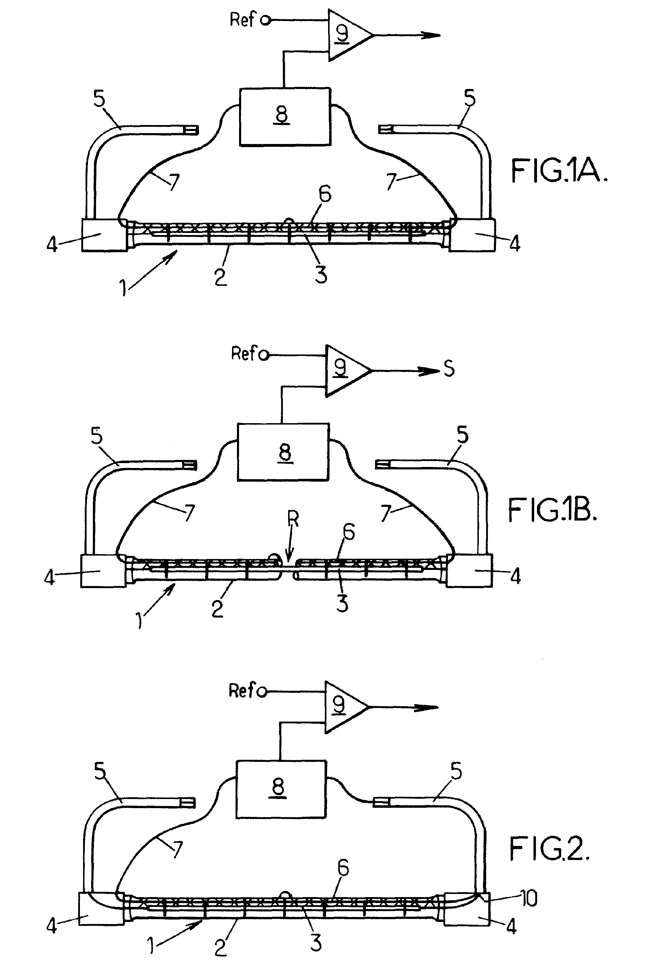

- les figures 1A et 1B sont des représentations très schématiques d'un premier mode de réalisation d'un agencement conforme à l'invention d'une lampe de chauffage dans une installation de chauffage d'ébauches en vue de la fabrication de récipients par soufflage ou étirage-soufflage, ce premier mode de réalisation étant illustré dans respectivement deux situations fonctionnelles différentes dans lesquelles l'enveloppe de la lampe est respectivement intacte et brisée ; et
- la figure 2 est une représentation très schématique d'un second mode de réalisation d'un agencement conforme à l'invention qui est une variante de celui montré à la figure 1A.

On se réfère maintenant aux figures 1A et 1B, et plus particulièrement tout d'abord à la figure 1A. L'invention se situe dans le contexte d'une installation de chauffage des corps d'ébauches en matière thermoplastique, en vue de la fabrication par soufflage ou étirage-soufflage de récipients tels que des bouteilles, des flacons ou autres. Une installation de chauffage de ce type comporte une multiplicité de lampes de chauffage à incandescence, en général du type à atmosphère d'halogène, propres à émettre un rayonnement électromagnétique infrarouge de température et de couleur données. Ces lampes, généralement en forme de tubes, sont disposées parallèlement les unes aux autres en colonnes et réparties en plusieurs colonnes successives, par exemple unilatéralement sur un côté de la trajectoire suivie par les corps des ébauches entraînées par un transporteur.

Sur la figure 1A est montrée très schématiquement la partie utile à la compréhension de l'invention de cette installation de chauffage, à savoir une lampe 1 (ici représentée dans sa forme tubulaire traditionnelle) qui possède une enveloppe 2, qui peut être notamment en verre ou en quartz, entourant un filament 3 ; des culots 4 aux extrémités respectives servent à sceller hermétiquement l'enveloppe et sont raccordés respectivement aux extrémités du filament 3 ; des fils 5 conducteurs externes sont raccordés soit directement aux culots 4 respectifs de la lampe 1 comme montré à la figure 1A, soit à des douilles (non montrées) de réception des culots 4 de la lampe.

La lampe 1 comporte un organe 6 électriquement conducteur qui est mécaniquement solidaire de ladite enveloppe 2, de telle sorte que toute atteinte à l'intégrité de ladite enveloppe 2 s'accompagne de façon certaine d'une discontinuité dans l'organe 6 conducteur, autrement dit que le bris de l'enveloppe 2 s'accompagne de la rupture de l'organe 6 conducteur. De préférence cet organe 6 conducteur s'étend sur toute la longueur de l'enveloppe 2, en particulier sur toute la longueur de l'enveloppe tubulaire dans l'exemple considéré, de manière que l'organe 6 conducteur puisse jouer son rôle quel que soit l'emplacement où l'enveloppe 2 pourra se briser.

Diverses solutions sont envisageables pour réaliser l'organe 6 conducteur.

Une première solution peut consister en ce que l'organe électriquement conducteur soit noyé dans la paroi de l'enveloppe : cette solution est certes efficace sur le plan de la solidarisation mécanique de l'organe 6 conducteur à l'enveloppe 2, de sorte que l'on est assuré, en choisissant l'organe 6 conducteur suffisamment peu résistant sur le plan mécanique (par exemple sous forme d'un fil ou d'un ruban métallique suffisamment fin), qu'il se rompra en même temps que l'enveloppe. Cependant, un tel agencement nécessite une fabrication spéciale des lampes, qui conduit nécessairement à des lampes sensiblement plus coûteuses que les lampes traditionnelles.

Une autre solution, qui actuellement semble préférable, consiste en ce que l'organe 6 conducteur adhère à une face de l'enveloppe 2, notamment à la face externe de l'enveloppe 2 ; en particulier, il est possible d'envisager de réaliser l'organe 6 conducteur sous forme d'une pulvérisation d'un film électriquement conducteur, typiquement métallique, sur la face externe de l'enveloppe 2. Une telle solution présente l'avantage que les lampes demeurent, dans leur structure d'ensemble, des lampes traditionnelles et que l'organe 6 conducteur n'est réalisé qu'au cours d'une étape finale qui ne présente aucune difficulté particulière (on sait réaliser de cette manière une calotte métallisée réfléchissante sur une ampoule en verre) : ainsi, le surcoût de fabrication de telles lampes reste modeste.

Quelle que soit la réalisation retenue, des fils 7 conducteurs sont raccordés aux extrémités respectives de l'organe 6 conducteur.

Des moyens 8 de détection, connectés auxdits fils conducteurs 7, sont propres à appliquer une tension électrique aux bornes de l'organe 6 conducteur et à détecter en permanence, lors du fonctionnement de l'installation, une grandeur électrique instantanée (telle que valeur de la tension appliquée à ses bornes, intensité du courant le traversant, valeur de sa résistance électrique) caractéristique dudit organe 6 conducteur.

Pour des raisons de fiabilité et de simplicité de mise en oeuvre, la solution la plus intéressante consiste à avoir recours à des moyens 8 détecteurs propres à détecter en permanence, au cours du fonctionnement de l'installation, la valeur de la résistance électrique de l'organe 6 conducteur, et des moyens indicateurs propres à donner une information représentative de l'état de l'organe conducteur, et donc de l'enveloppe.

Un simple appareil de mesure électrique à afficheur pourrait certes suffire pour fournir l'information requise de manière qu'un opérateur puisse prendre les mesures nécessaires en cas de détection de défaut. Toutefois, compte tenu du grand nombre de lampes présentes en pratique dans une installation de chauffage visée par l'invention, il est préférable de prévoir, comme montré à la figure 1A, que les moyens indicateurs comprennent des moyens 9 comparateurs propres à comparer la valeur, détectée par les moyens 8 détecteurs, de la grandeur électrique à un seuil prédéterminé Ref et à émettre un signal S lorsque ladite grandeur électrique mesurée se situe de façon prédéfinie par rapport audit seuil prédéterminé et devient représentative de la rupture R de l'organe 6 conducteur accompagnant un bris de l'enveloppe 2 de la lampe 1 alors que le filament 3 est encore intact, comme montré à la figure 1B : il devient alors possible d'exploiter le signal S ainsi généré par exemple pour provoquer automatiquement une coupure de l'alimentation électrique de la lampe incriminée et/ou déclencher une alarme ou une signalisation appropriée, voire un arrêt complet de l'installation.

Dans un exemple pratique de réalisation qui est simple, structurellement et fonctionnellement, à mettre en oeuvre, les moyens 8 de détection sont propres à détecter en permanence, lors du fonctionnement de l'installation, la résistance électrique dudit organe 6 conducteur et les moyens 9 comparateurs sont propres à délivrer un signal S lorsque ladite résistance électrique détectée devient supérieure à un seuil prédéterminé, notamment devient sensiblement infinie et caractérise une rupture R de l'organe 6 conducteur comme montré à la figure 1B.

L'intérêt offert par la solution technique proposée par l'invention réside dans sa très grande souplesse de mise en oeuvre, eu égard au fait qu'une installation de chauffage du type visé par l'invention comporte, comme cela a été indiqué plus haut, un grand nombre de lampes. Il en résulte que de nombreuses variantes de réalisation peuvent être trouvées.

Dans le mode de réalisation montré aux figures 1A et 1B, toutes les lampes de l'installation sont équipées d'organes 6 conducteurs respectifs et des moyens 8 de détection sont fonctionnellement associés de façon individuelle auxdits organes 6 conducteurs respectifs des lampes. Ainsi, les enveloppes 2 des lampes sont surveillées individuellement et, en cas d'avarie, une signalisation identifie celle parmi toutes les lampes qui est concernée.

Toutefois, une simplification structurelle et un moindre coût pourraient être obtenus, et plusieurs solutions sont envisageables à cet effet.

Une première solution peut consister à maintenir des moyens 8 de détection associés individuellement à chaque lampe 1 ; par contre, les sorties de tous les moyens 8 de détection associés à un groupe défini de lampes (par exemple toutes les lampes d'une colonne) sont raccordées à des entrées respectives d'un même moyen 9 comparateur, de sorte que celui-ci émet un signal S lorsque l'enveloppe 2 d'une lampe quelconque du groupe de lampes est brisée.

Une autre solution, encore plus simple et encore moins coûteuse, peut consister en ce que tous les organes 6 conducteurs des lampes d'un groupe défini de lampes (par exemple toutes les lampes d'une colonne, ou toutes les lampes d'un bloc de chauffage) soient connectés électriquement en série et en ce que lesdits moyens de détection soient connectés aux bornes de l'ensemble des organes conducteurs en série dudit groupe de lampes. Là encore, avec des moyens très simples, on obtient une signalisation efficace.

Indépendamment de la manière dont les organes conducteurs des lampes peuvent être traités dans les circuits extérieurs, il est possible de concevoir d'autres modes de montage de l'organe conducteur au sein de la lampe.

A titre d'exemple, dans la lampe montrée à la figure 2 une extrémité de l'organe 6 conducteur (extrémité de droite sur le dessin) est raccordée au fil d'alimentation 10 situé de ce côté. Il en résulte une lampe pourvue de seulement trois fils, deux fils d'alimentation et un fil pour le contrôle, ce qui réduit le coût de fabrication de la lampe et simplifie son raccordement dans l'installation. Le mode de fonctionnement demeure identique à ce qui a été exposé plus haut.

## Revendications

1. Procédé de détection de l'état d'au moins une lampe (1) de chauffage de corps d'ébauches en matière thermoplastique, en vue de la fabrication de récipients par soufflage ou étirage-soufflage, cette lampe (1) étant une lampe à incandescence de rayonnement électromagnétique infrarouge qui possède une enveloppe (2) entourant un filament (3),
**caractérisé**
**en ce qu'**on équipe ladite lampe (1) d'un organe (6) électriquement conducteur qui est mécaniquement solidaire de ladite enveloppe (2),
**en ce qu'**on place ledit organe (6) conducteur sous tension électrique et on détecte (en 8) en permanence une grandeur électrique aux bornes dudit organe (6) conducteur lorsque la lampe (1) est en fonctionnement, et
**en ce qu'**on délivre une information représentative de l'état de l'organe (6) conducteur, et donc de l'enveloppe (2).

2. Procédé selon la revendication 1, **caractérisé en ce qu'**on détecte (en 8) en permanence la résistance électrique aux bornes dudit organe (6) conducteur lorsque la lampe (1) est en fonctionnement et **en ce qu'**on délivre un signal (S) si la résistance mesurée dudit organe conducteur devient supérieure à un seuil (Ref) prédéterminé, notamment devient sensiblement infinie.

3. Procédé selon la revendication 2, **caractérisé en ce qu'**avec le signal (S) on déclenche une coupure de l'alimentation électrique de la lampe et/ou une alerte et/ou l'arrêt du chauffage et/ou un arrêt complet de l'installation.

4. Procédé selon l'une quelconque des revendications 1 à 3, **caractérisé en ce qu'**il est prévu plusieurs lampes (1) de chauffage chacune équipée d'un organe (6) conducteur qui est mécaniquement solidaire de sa propre enveloppe (2), **en ce que** tous les organes (6) conducteurs sont électriquement indépendants les uns des autres et **en ce que** la détection (en 8) de la susdite grandeur électrique est menée sur chaque organe (6) conducteur de chaque lampe (1).

5. Procédé selon l'une quelconque des revendications 1 à 3, **caractérisé en ce qu'**il est prévu plusieurs lampes (1) de chauffage chacune équipée d'un organe (6) conducteur qui est mécaniquement solidaire de sa propre enveloppe (2), **en ce que** plusieurs organes (6) conducteurs appartenant aux lampes (1) respectives d'un groupe de lampes sont connectés électriquement en série et **en ce que** la détection de la susdite grandeur électrique est menée aux bornes de l'ensemble des organes (6) conducteurs en série dudit groupe de lampes.

6. Installation de chauffage des corps d'ébauches en matière thermoplastique, en vue de la fabrication de récipients par soufflage ou étirage-soufflage, cette installation de chauffage comportant au moins une lampe (1) incandescente de rayonnement électromagnétique infrarouge qui possède une enveloppe (2) entourant un filament (3),
**caractérisée**
**en ce que** ladite lampe (1) comporte un organe (6) électriquement conducteur qui est mécaniquement solidaire de ladite enveloppe (2), et
**en ce que** l'installation comprend
. des moyens (8) de détection propres à détecter en permanence, lors du fonctionnement de l'installation, une grandeur électrique instantanée dudit organe (6) conducteur placé sous tension électrique et
. des moyens indicateurs propres à donner une information représentative de l'état de l'organe (6) conducteur, et donc de l'enveloppe (2) de la lampe.

7. Installation selon la revendication 6, **caractérisée en que** les moyens indicateurs comprennent des moyens (9) comparateurs propres à comparer la valeur détectée de la grandeur électrique à un seuil (Ref) prédéterminé et à émettre un signal (S) lorsque ladite grandeur électrique mesurée se situe de façon prédéfinie par rapport audit seuil (Ref) prédéterminé.

8. Installation selon la revendication 7, **caractérisée en que** les moyens (8) de détection sont propres à détecter en permanence, lors du fonctionnement de l'installation, la résistance électrique dudit organe (6) conducteur et en ce que les moyens (9) comparateurs sont propres à délivrer un signal (S) lorsque ladite résistance électrique détectée devient supérieure à un seuil prédéterminé, notamment devient sensiblement infinie.

9. Installation selon l'une quelconque des revendications 6 à 8, **caractérisée en ce que** la lampe (1) est en forme générale de tube et **en ce que** l'organe (6) conducteur s'étend sur toute la longueur de l'enveloppe (2).

10. Installation selon l'une quelconque des revendications 6 à 9, **caractérisée en ce que** l'organe (6) conducteur est noyé dans la paroi de l'enveloppe (2).

11. Installation selon la revendication 10, **caractérisée en ce que** l'organe (6) conducteur est un fil ou un ruban métallique.

12. Installation selon l'une quelconque des revendications 6 à 9, **caractérisée en ce que** l'organe (6) conducteur adhère à une face de l'enveloppe (2).

13. Installation selon la revendication 12, **caractérisée en ce que** l'organe (6) conducteur adhère à la face externe de l'enveloppe (2).

14. Installation selon la revendication 13, **caractérisée en ce que** l'organe (6) conducteur est un revêtement d'un film électriquement conducteur sur la face externe de l'enveloppe (2).

15. Installation selon l'une quelconque des revendications 6 à 14, **caractérisée en ce qu'**elle comporte plusieurs lampes (1) équipées d'organes (6) conducteurs respectifs et **en ce que** des moyens (8) de détection sont fonctionnellement associés de façon individuelle auxdits organes (6) conducteurs respectifs des lampes (1).

16. Installation selon l'une quelconque des revendications 6 à 14, **caractérisée en ce qu'**elle comporte plusieurs lampes (1) équipées d'organes (6) conducteurs respectifs, en que plusieurs organes (6) conducteurs appartenant aux lampes respectives d'un groupe de lampes sont connectés électriquement en série et **en ce que** lesdits moyens (8) de détection sont connectés aux bornes de l'ensemble des organes (6) conducteurs en série dudit groupe de lampes.
